(19) Europäisches Patentamt
European Patent Office
Office européen des brevets

(11) **EP 3 925 072 B1**

(12) **EUROPÄISCHE PATENTSCHRIFT**

(45) Veröffentlichungstag und Bekanntmachung des Hinweises auf die Patenterteilung:
**22.01.2025 Patentblatt 2025/04**

(21) Anmeldenummer: **20714878.4**

(22) Anmeldetag: **11.03.2020**

(51) Internationale Patentklassifikation (IPC):
*H03K 17/081* (2006.01)    *H03K 17/16* (2006.01)
*H02H 3/06* (2006.01)    *H02H 3/08* (2006.01)
*H02H 3/087* (2006.01)    *H02H 7/26* (2006.01)
*H01H 9/54* (2006.01)    *H03K 17/51* (2006.01)

(52) Gemeinsame Patentklassifikation (CPC):
**H02H 7/268; H02H 3/066; H02H 3/081;**
**H03K 17/081; H03K 17/168; H01H 9/548;**
**H02H 3/087; H03K 2017/515**

(86) Internationale Anmeldenummer:
**PCT/EP2020/056449**

(87) Internationale Veröffentlichungsnummer:
**WO 2020/193134 (01.10.2020 Gazette 2020/40)**

(54) **GLEICHSPANNUNGSSCHALTER**

DC VOLTAGE SWITCH

COMMUTATEUR DE TENSION CONTINUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.03.2019 DE 102019203983**

(43) Veröffentlichungstag der Anmeldung:
**22.12.2021 Patentblatt 2021/51**

(73) Patentinhaber: **Siemens Aktiengesellschaft 80333 München (DE)**

(72) Erfinder:
• BECKERT, Thomas
  **90461 Nürnberg (DE)**
• WEIDAUER, Jens
  **90763 Fürth (DE)**

(74) Vertreter: **Siemens Patent Attorneys Postfach 22 16 34 80506 München (DE)**

(56) Entgegenhaltungen:
**EP-A1- 3 051 646        WO-A1-2014/139559**
**WO-A1-2017/220443**

**Beschreibung**

Die Erfindung betrifft einen Gleichspannungsschalter zum Koppeln eines Gleichspannungsgerätes oder Gleichspannungsabzweiges mit einem Plus- und einem Minusleiter an einen Gleichspannungsbus und ein zugehöriges Verfahren.

Mit Gleichspannung sind Spannungen bis 1500 Volt gemeint. Gleichspannungen bis zu dieser Höhe werden auch als Niederspannung bezeichnet. Mit Gleichspannung sind spezieller insbesondere Spannungen gemeint, die größer als die Kleinspannung mit einer Höhe von 120 Volt Gleichspannung sind. Mit Gleichspannung sind insbesondere Spannungen von 400-800 Volt gemeint.

Mit Gleichspannungsstromkreis bzw. Gleichstromkreis sind Stromkreise für Ströme, insbesondere Nennströme bzw. maximal Ströme, von 2 bis 1000 Ampere; spezieller für Ströme von 2 Ampere bis 400 Ampere oder 200 Ampere gemeint.

Mit Gleichspannungsbus ist ein mindestens Zweileitersystem mit einem Plusleiter und einem Minusleiter gemeint, das von mindestens einer Energiequelle mit Gleichspannung versorgt wird. An den Gleichspannungsbus ist über jeweils einen Gleichspannungsabzweig ein (Gleichspannungs-)Gerät, z.B. ein Gleichspannungsverbraucher, Last, Wechselrichter, kombinierte Energiesenke oder Energiequelle, reine (weitere) Energiequelle, etc., angeschlossen. An einem Gleichspannungsabzweig können auch mehrere Gleichspannungsgeräte angeschlossen sein.

Mit Gleichspannungsgerät ist insbesondere ein Gerät mit einer Leistung von 1 Kilowatt bis 500 Kilowatt gemeint.

Mittlerweile werden verstärkt Gleichspannungsstromkreise, auch als Gleichspannungsnetze respektive Niederspannungsgleichstromnetze bezeichnet, entwickelt und aufgebaut, die üblicherweise einen Gleichspannungsbus mit Gleichspannungsabzweigen aufweisen.

Die Gleichspannungsabzweige, auch als Verbraucherabzweige bezeichnet, werden üblicherweise über einen Gleichspannungsschalter (DC Schalter) abgesichert. Diese Gleichspannungsschalter weisen eine Schalteinrichtung auf.

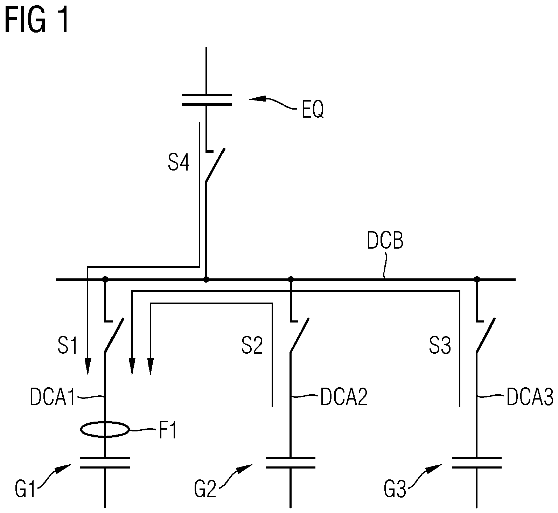

Eine Prinzipdarstellung eines Gleichspannungsstromkreises, Gleichspannungsnetzes, Niederspannungsgleichstromnetzes bzw. DC-Netzes mit einem Gleichspannungsbus DCB und mehreren Gleichspannungsabzweigen DCA1, DCA2, DCA3 mit Gleichspannungsschaltern S1, S2, S3 zeigt Figur 1.

Figur 1 zeigt prinziphaft eine Gleichspannungsquelle EQ die über einen Einspeiseschalter S4 mit einem Gleichspannungsbus DCB verbunden ist. Am Gleichspannungsbus DCB ist über einen ersten Gleichspannungsschalter S1 ein erster Gleichspannungsabzweig DCA1 mit mindestens einem ersten Gleichspannungsgerät G1 angeschlossen; in analoger Weise über einen zweiten Gleichspannungsschalter S2 ein zweiter Gleichspannungsabzweig DCA2 mit mindestens einem zweiten Gleichspannungsgerät G2 angeschlossen, über einen dritten Gleichspannungsschalter S3 ein dritter Gleichspannungsabzweig DCA3 mit mindestens einem dritten Gleichspannungsgerät G3 angeschlossen.

Weitere Gleichspannungsschalter, Gleichspannungsabzweige, Gleichspannungsgeräte können vorgesehen sein. Die Gleichspannungsschalter können Abgangsschalter sein. Die Gleichspannungsgeräte weisen üblicherweise eine elektrische Kapazität auf, die nicht unerhebliche Energiemenggen speichern können.

Tritt in dem Gleichspannungsstromkreis gemäß Figur 1 ein Fehler auf, z.B. ein Kurzschluss im ersten Gleichspannungsabzweig DCA1 an der Fehlerstelle F1, die sich zwischen erstem Gleichspannungsschalter S1 und ersten (Gleichspannungs-)Gerät G1 befindet, so wird der dortige Kurzschluss aus der Energiequelle EQ sowie ferner aus den umliegenden Gleichspannungsabzweigen, im Beispiel dem zweiten und dritten Gleichspannungsabzweig DCA2, DCA3, respektive den sich darin befindlichen Energiequellen bzw. Kapazitäten (der Geräte) gespeist. Dies führt zu einem hohen Strom in der zugehörigen Schalteinrichtung, im Beispiel im zweiten bzw. dritten Gleichspannungsschalter S2, S3, die mit einer Abschaltung auslöst / auslösen können.

Das zweite und dritte Gerät G2, G3 bzw. dessen Kapazitäten können einen hohen (Fehler-)Strom liefern. Besitzt beispielsweise das zweite Gerät G2 einen kleinen Nennstrom, so ist der zweite Gleichspannungsschalter S2 dementsprechend klein bemessen und kann den Stromfluss unterbrechen, auch wenn der Fehler in einem anderen Abzweig aufgetreten ist.

Grundsätzlich sollen die umliegenden Gleichspannungsschalter (S2, S3) den Stromfluss aus dem jeweiligen Gleichspannungsabzweig bzw. Verbraucherabzweig zum Kurzschluss F1 möglichst wenig behindern, damit der Gleichspannungsschalter, im Beispiel der erste Gleichspannungsschalter S1, sicher auslöst.

Weiterhin wichtig dabei ist, dass die umliegenden Gleichspannungsschalter (S2, S3) nicht auslösen, so dass ein so genanntes selektives Abschalten des Fehlers (durch S1) erfolgt.

Dies ist, wie oben dargestellt, nicht immer sichergestellt. Insbesondere wenn die umliegenden Gleichspannungsschalter Schalteinrichtungen mit Halbleiterschaltelementen aufweisen. Die Halbleiterschaltelemente weisen meist einen Sättigungsstrom auf, der kleiner als der Kurzschlussstrom im Fehlerfall ist, und wirken somit strombegrenzend. Dieser Sättigungsstrom kann zudem nur für kurze Zeit, meist im einstelligen ps Bereich, durch das Halbleiterschaltelement getragen werden. Die Gleichspannungsschalter müssen zum Schutz des Halbleiterschaltelementes deshalb ohne Berücksichtigung der geforderten Selektivität ausschalten (Eigenschutz), d.h. den Stromfluss unterbrechen.

Beispielsweise offenbart die WO 2014/139559 A1 einen Hochleistungsschalter zur Unterbrechung von DC-Stromkreisen mit zwei Strompfaden für hohe Leistungen, wobei mindestens zwei in einem der Strompfade antiseriell geschaltete Transistoren derart vorgesehen sind, dass jeder Transistor genau eine der beiden möglichen Stromrichtungen gesperrt oder durchschalten kann.

Bislang wurde dieses Problem dadurch gelöst, dass die Gleichspannungsschalter entweder elektromechanische Schalteinrichtungen aufweisen oder stark überdimensioniert wurden, was teuer bzw. nicht ökonomisch ist.

Aufgabe der vorliegenden Erfindung ist es, das Schaltverhalten von Gleichspannungsschaltern zur Erzielung von Selektivität zu verbessern, insbesondere für Gleichspannungsschalter mit halbleiterbasierten Schalteinrichtungen eine Lösung für das genannte Problem anzugeben.

Dieses Problem wird durch einen Gleichspannungsschalter mit den Merkmalen des Patentanspruchs 1 oder ein Verfahren mit den Merkmalen des Patentanspruchs 16 gelöst.

Erfindungsgemäß wird ein Gleichspannungsschalter zum Koppeln eines für mindestens ein Gleichspannungsgerät vorgesehenen Gleichspannungsabzweiges mit einem Plus- und einem Minusleiter an einen Gleichspannungsbus vorgeschlagen, wobei eine Vorwärtsrichtung des elektrischen Stromes durch einen Stromfluss vom Plusleiter des Gleichspannungsbusses DCB über den Gleichspannungsschalter zum Plusleiter des Gleichspannungsabzweiges sowie vom Minusleiter des Gleichspannungsabzweiges über den Gleichspannungsschalter zum Minusleiter des Gleichspannungsbusses definiert ist.

Eine Rückwärtsrichtung des elektrischen Stromes ist folglich vom Plusleiter des Gleichspannungsabzweiges über den Gleichspannungsschalter zum Plusleiter des Gleichspannungsbusses sowie vom Minusleiter des Gleichspannungsbusses über den Gleichspannungsschalter zum Minusleiter des Gleichspannungsabzweiges definiert.

Der Gleichspannungsschalter weist auf:

- eine halbleiterbasierte, elektronisch steuerbare Schalteinrichtung,
- einen vor der Schalteinrichtung vorgesehenen gleichspannungsbusseitigen Spannungssensor, zur Ermittlung der gleichspannungsbusseitigen Spannungshöhe,
- einen nach der Schalteinrichtung vorgesehenen gleichspannungsabzweigseitigen Spannungssensor, zur Ermittlung der gleichspannungsabzweigseitigen Spannungshöhe,
- einen Stromsensor zur Ermittlung der Stromhöhe und der Stromrichtung,
- eine Steuereinrichtung, die mit der Schalteinrichtung, den Spannungssensoren und dem Stromsensor verbunden ist.

Die Steuereinrichtung ist derart ausgestaltet, dass

- die Richtung des Stromes und die Stromhöhe ermittelt wird, insbesondere periodisch die Richtung und Stromhöhe ermittelt wird,
- bei Überschreitung eines ersten Schwellwertes (Stromschwellwert) der Stromhöhe erfolgt eine Unterbrechung des Stromflusses durch die Schalteinrichtung,
- falls bei Überschreitung des ersten Schwellwertes der Stromhöhe die ermittelte Richtung des Stroms die Rückwärtsrichtung ist:
- wird nach Unterbrechung des Stromflusses die gleichspannungsbusseitige mit der gleichspannungsabzweigseitigen Spannungshöhe verglichen, bei einem Spannungsunterschied, der kleiner als ein Spannungsdifferenzwert ist, wird die Schalteinrichtung leitfähig geschaltet.

Dies hat den Vorteil, dass bei einem versehentlichen Abschalten des Gleichspannungsschalters bei zu hohem Stromfluss ein Wiedereinschalten dann erfolgt, wenn der zur Abschaltung führende Strom (Stromhöhe) nicht zum Gleichspannungsgerät, sondern vom Gleichspannungsgerät zum Gleichspannungsbus geflossen ist. D.h. ein Fehler nicht im Gleichspannungsabzweig des Gleichspannungsschalters vorliegt, sondern auf Seiten des Gleichspannungsbusses bzw. eines anderen Gleichspannungsabzweig. Ferner, wenn die Spannungshöhe auf dem Gleichspannungsbus wieder einem Wert entspricht, der in etwa der Spannungshöhe im Gleichspannungsabzweig entspricht. In einem solchen Fall kann davon ausgegangen werden, dass ein fehlerbehafteter Abzweig abgeschaltet wurde und sich die Spannung auf dem Gleichspannungsbus normalisiert hat, so dass fehlerfreie Gleichspannungsabzweige, die versehentlich abschalten mussten, bestimmungsgemäß weiter versorgt werden.

Vorteilhafte Ausgestaltungen der Erfindung sind in den Unteransprüchen angegeben.

In einer vorteilhaften Ausgestaltung der Erfindung weist die Schalteinrichtung mindestens ein, insbesondere zwei,

den plus- oder minusleiterseitigen Stromfluss führendes Halbleierschaltelement auf.

Dies hat den besonderen Vorteil, dass eine besonders einfache Lösung für eine Schalteinrichtung gegeben ist.

In einer vorteilhaften Ausgestaltung der Erfindung ist das Halbleiterschaltelement ein Bipolartransistor mit isolierter Gate-Elektrode, ein Metall-Oxid-Halbleiter-Feldeffekttransistor oder ein Galliumnitrid-Transistor.

Dies hat den besonderen Vorteil, dass eine einfache Lösung für die Halbleiterschaltelemente des Schaltmoduls gegeben ist.

In einer vorteilhaften Ausgestaltung der Erfindung ist dem Halbleiterschaltelement eine Diode parallel geschaltet, insbesondere mit ihrer Durchlassrichtung entgegen der Durchlassrichtung des Halbleiterschaltelementes.

Dies hat den besonderen Vorteil, dass eine einfache Lösung für unidirektionale Halbleiterschaltelemente, insbesondere bei Serienschaltung zweier unidirektionale Halbleiterschaltelemente, gegeben ist.

In einer vorteilhaften Ausgestaltung der Erfindung weist die Diode eine niedrige Durchlassspannung auf, insbesondere ist es eine Netzdiode oder Schottkydiode.

Dies hat den besonderen Vorteil, dass ein besonders niedriger Spannungsabfall in Rückwärtsrichtung vorliegt, wodurch einerseits eine geringe Verlustleistung vorliegt und andererseits ein maximaler Strom in Rückwärtsrichtung zur Erhöhung der Selektivität gegeben ist.

In einer vorteilhaften Ausgestaltung der Erfindung ist der Gleichspannungsschalter in einem Gehäuse angeordnet.

Dies hat den besonderen Vorteil, dass ein kompakter Gleichspannungsschalter in einem Gehäuse zur Verfügung steht.

In einer vorteilhaften Ausgestaltung der Erfindung weist das Gehäuse einen Plusleitereingangsanschluss, einen Minusleitereingangsanschluss, einen Plusleiterausgangsanschluss und einen Minusleiterausgangsanschluss auf. Die Eingangsanschlüsse sind mit dem Gleichspannungsbus verbindbar. Die Ausgangsanschlüsse sind mit dem Gleichspannungsabzweig verbindbar.

Die Schalteinrichtung verbindet den Plusleitereingangsanschluss mit dem Plusleiterausgangsanschluss oder die Schalteinrichtung verbindet den Minusleitereingangsanschluss mit dem Minusleiterausgangsanschluss.

In einer Variante können im Plus- und Minusleiter Schalteinrichtungen vorgesehen sein.

Dies hat den besonderen Vorteil, dass eine einfache Lösung für einen kompakten Gleichspannungsschalter zur Verfügung steht.

In einer vorteilhaften Ausgestaltung der Erfindung sind die nicht die Schalteinrichtung aufweisenden Anschlüsse durch eine elektrische Leitung miteinander verbunden.

Dies hat den besonderen Vorteil, dass eine einfache Lösung, insbesondere einpolig schaltende Lösung, für einen Gleichspannungsschaler gegeben ist.

In einer vorteilhaften Ausgestaltung der Erfindung beträgt der Spannungsdifferenzwert 10 Volt.

Dies hat den besonderen Vorteil, dass zu hohe Ausgleichsströme zwischen Gleichspannungsabzweig und Gleichspannungsbus minimiert werden bzw. die Spannungsdifferenz ein hohes Maß überschreitet.

In einer vorteilhaften Ausgestaltung der Erfindung ist der Stromsensor ein Sensor auf Basis des Hall-Effekts.

Dies hat den besonderen Vorteil, dass eine einfache Lösung für die Ermittlung der Höhe und Richtung des Stromes gegeben ist.

In einer vorteilhaften Ausgestaltung der Erfindung ist die Steuereinrichtung ferner derart ausgestaltet ist, dass bei einem Anstieg des Stromes, der einen Stromanstiegsschwellwert überschreitet, eine Unterbrechung des Stromflusses durch die Schalteinrichtung erfolgt.

Dies hat den besonderen Vorteil, dass ein weiteres Schutzkriterium des Gleichspannungsschalters für eine gezielte Auslösung bzw. den Eigenschutz gegeben ist.

In einer vorteilhaften Ausgestaltung der Erfindung ist ein Netzteil, Energiespeicher oder ein Anschluss für eine externe Energieversorgung für die Steuereinrichtung vorgesehen.

Dies hat den besonderen Vorteil, dass insbesondere eine Energieversorgung nach Auslösen des Gleichspannungsschalters gegeben ist.

In einer vorteilhaften Ausgestaltung der Erfindung weist die Steuereinrichtung einen Mikroprozessor auf.

Dies hat den besonderen Vorteil, dass eine besonders komfortable bzw. änderbare Steuerung der Gleichspannungsschalters ermöglicht wird.

Alle Ausgestaltungen, sowohl in abhängiger Form rückbezogen auf den Patentanspruch 1 oder 16 als auch rückbezogen lediglich auf einzelne Merkmale oder Merkmalskombinationen von Patentansprüchen, bewirken eine Verbesserung eines Gleichspannungsschalters zur Verbesserung der Selektivität in einem Gleichspannungsnetz. Dadurch können insbesondere Geräte unterschiedlicher Leistungsklassen an einem gemeinsamen Gleichspannungsbus betrieben werden.

Die beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit der Zeichnung näher erläutert werden.

In der zugehörigen Zeichnung zeigt:

Figur 1 eine Prinzipdarstellung eines Gleichspannungsstromkreises mit einem Gleichspannungsbus und mehreren Gleichspannungsabzweigen mit Gleichspannungsschaltern,

Figur 2 eine Darstellung eines Gleichspannungsschalters mit Gleichspannungsbus, Gleichspannungsabzweig und Gleichspannungsgerät gemäß der Erfindung,

Figur 3 ein Beispiel für eine Schalteinrichtung mit Halbleiterschaltelementen.

Figur 1 zeigt eine Prinzipdarstellung eines Gleichspannungsstromkreises mit einem Gleichspannungsbus und mehreren Gleichspannungsabzweigen mit Gleichspannungsschaltern gemäß dem Stand der Technik, wie sie bereits eingangs beschrieben wurde.

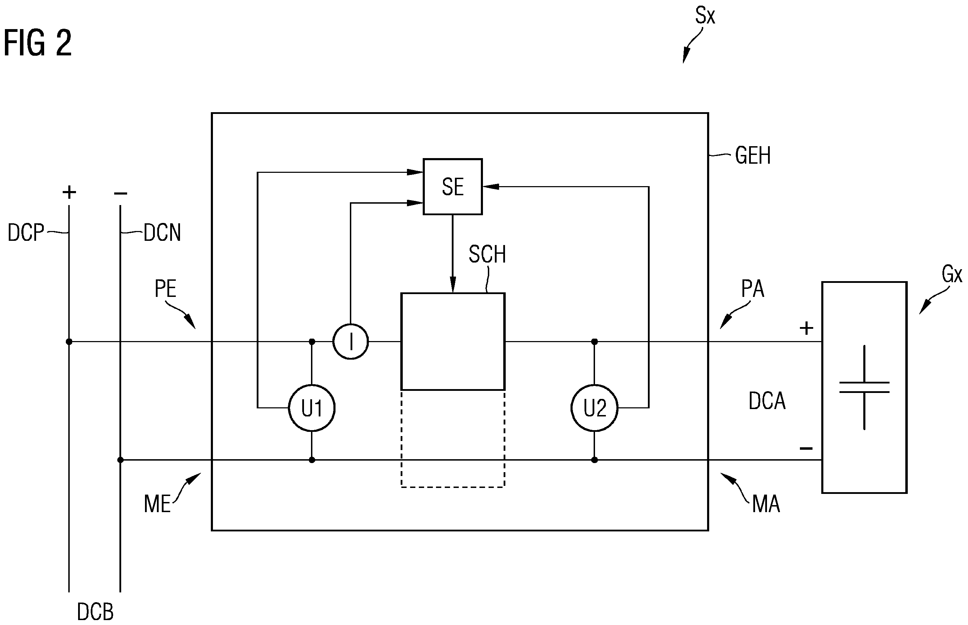

Figur 2 einen Gleichspannungsschalter Sx, wie er beispielsweise als erster, zweiter oder dritter Schalter S1, S2, S3 gemäß Figur 1 eingesetzt werden könnte, mit einem Gehäuse GEH. Das Gehäuse GEH weist einen Plusleitereingangsanschluss PE, einen Minusleitereingangsanschluss ME, einen Plusleiterausgangsanschluss PA und einen Minusleiterausgangsanschluss MA auf.

Die Eingangsanschlüsse PE, ME sind mit dem Gleichspannungsbus DCB verbunden, der einen Plusleiter DCP (+) und einen Minusleiter DCN (-) aufweist.

Die Ausgangsanschlüsse PA, MA sind mit einem Gleichspannungsabzweig DCA verbunden, der wiederum mit mindestens einem Gelichspannungsgerät Gx verbunden ist, beispielsweise ein erstes, zweites oder drittes Gerät G1, G2, G3 gemäß Figur 1.

Der Gleichspannungsschalter Sx weist eine Schalteinrichtung SCH auf.

Gehäuseintern verbindet die Schalteinrichtung SCH entweder den Plusleitereingangsanschluss PE mit dem Plusleiterausgangsanschluss PA, wie dargestellt, oder den Minusleitereingangsanschluss ME mit dem Minusleiterausgangsanschluss MA.

Alternativ können auch zwei Schalteinrichtungen, eine erste und eine zweite Schalteinrichtung, vorgesehen sein. Wobei die erste Schalteinrichtung für die Plusleiteranschlüsse und die zweite Schalteinrichtung für die Minusleiteranschlüsse vorgesehen ist.

Gemäß Figur 2 sind die nicht die Schalteinrichtung SCH aufweisenden Anschlüsse durch eine elektrische Leitung miteinander verbunden, im Beispiel ist der Minusleitereingangsanschluss ME durch die elektrische Leitung mit dem Minusleiterausgangsanschluss MA verbunden.

Vor der Schalteinrichtung SCH, d.h. auf Seiten des Gleichspannungsbusses DCB, ist ein gleichspannungsbusseitiger Spannungssensor U1 zwischen Plus- und Minusleiter vorgesehen, zur Ermittlung der gleichspannungsbusseitigen Spannungshöhe.

Nach der Schalteinrichtung SCH, d.h. auf Seiten des Gleichspannungsabzweiges DCA, ist ein gleichspannungsabzweigseitigen Spannungssensor U2 zwischen Plus- und Minusleiter vorgesehenen, zur Ermittlung der gleichspannungsabzweigseitigen Spannungshöhe.

Im Plusleiter oder Minusleiter, vor oder nach der Schalteinrichtung SCH, ist ein Stromsensor I zur Ermittlung der Stromhöhe und der Stromrichtung vorgesehen. Der Stromsensor kann ein Sensor auf Basis des Hall-Effekts sein.

Die Schalteinrichtung SCH ist eine halbleiterbasierte, elektronisch steuerbare Schalteinrichtung SCH. Sie kann mindestens ein den (je nach Lage plus- oder minusleiterseitigen) Stromfluss führendes Halbleierschaltelement aufweisen. Insbesondere können zwei den (je nach Lage plus- oder minusleiterseitigen) Stromfluss führende Halbleierschaltelemente vorgesehen sein. Das Halbleiterschaltelement kann ein Bipolartransistor mit isolierter Gate-Elektrode, ein Metall-Oxid-Halbleiter-Feldeffekttransistor oder ein Galliumnitrid-Transistor sein.

Dem Halbleiterschaltelement kann eine Diode parallel geschaltet sein, insbesondere mit ihrer Durchlassrichtung entgegen der Durchlassrichtung des Halbleiterschaltelementes. Die Diode kann eine niedrige Durchlassspannung aufweisen, insbesondere eine Netzdiode oder Schottkydiode sein.

Es ist eine Steuereinrichtung SE vorgesehen, die mit der Schalteinrichtung SCH, den Spannungssensoren U1, U2 und dem Stromsensor I verbunden ist. Die Dann Steuereinrichtung SE kann einen Mikroprozessor aufweisen.

Die Steuereinrichtung kann durch ein (nicht dargestelltes) Netzteil mit Energie versorgt werden. Das Netzteil kann an den gleichspannungsbusseitigen Eingangsanschlüssen oder/und gleichspannungsabzweigseitigen Ausgangsanschlüssen angeschlossen sein.

Alternativ oder zusätzlich kann ein Energiespeicher, wie ein Superkondensator, ein Akkumulator oder eine Batterie, vorgesehen sein, zur Energieversorgung der Steuereinrichtung SE für den Fall der Auslösung oder eines Kurzschlusses/Fehlerfalls auf einen Gleichspannungsabzweig DCA1, DCA2, DCA3 oder dem Gleichspannungsbus DCB. Alternativ kann ein Anschluss für eine externe Energieversorgung für die Steuereinrichtung und ggfs. weitere Einrichtungen des Gleichspannungsschalters Sx vorgesehen sein.

Die Steuereinrichtung ist derart ausgestaltet, dass

- (insbesondere periodisch) die Richtung des Stromes und die Stromhöhe ermittelt wird,
- bei Überschreitung eines ersten Schwellwertes der Stromhöhe, d.h. eines Stromschwellwertes, eine Unterbrechung des Stromflusses durch die Schalteinrichtung SCH erfolgt,

- bei vorliegender Rückwärtsrichtung des Stromes kurz vor bzw. während der Überschreitung des ersten Schwellwertes der Stromhöhe:
- nach Unterbrechung des Stromflusses die gleichspannungsbusseitige mit der gleichspannungsabzweigseitigen Spannungshöhe (periodisch) verglichen wird und bei einem Spannungsunterschied, der kleiner als ein Spannungsdifferenzwert ist, die Schalteinrichtung leitfähig geschaltet wird. Beispielsweise kann dieser Spannungsdifferenzwert 10 Volt betragen. D.h. wenn der Spannungsunterschied zwischen Gleichspannungsbus DCB und Gleichspannungsabzweig DCA kleiner als 10 Volt ist, wird die Schalteinrichtung SCH durch die Steuereinrichtung SE wieder eingeschaltet, die Schalteinrichtung SCH wird für den elektrischen Stromfluss leitfähig.

Zusätzlich kann die Steuereinrichtung SE ferner derart ausgestaltet sein, dass bei einem Anstieg des Stromes, der einen Stromanstiegsschwellwert überschreitet, eine Unterbrechung des Stromflusses durch die Schalteinrichtung erfolgt. Auch nach einer derartigen Unterbrechung kann die Erfindung eingesetzt werden und bei Stromfluss in Rückwärtsrichtung zum Zeitpunkt der Auslösung/Stromunterbrechung ein Vergleich der Spannungen und ggfs. Einschalten erfolgen.

Im Plusleiter oder Minusleiter, vor oder nach der Schalteinrichtung SCH, können ferner in einem oder beiden Leitern (Plus-, Minusleiter) Trennkontakte bzw. ein Trennschalter vorgesehen sein, zur galvanischen Trennung des Gleichspannungsgerätes bzw. Gleichspannungsschalters. Die Trennkontakte können durch die Steuereinrichtung SE schaltbar sein.

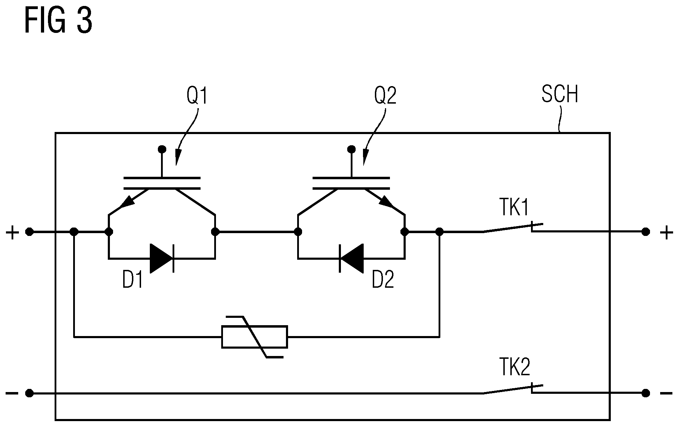

Figur 3 zeigt ein Beispiel für eine Schalteinrichtung SCH mit Halbleiterschaltelementen. Die Schalteinrichtung SCH weist eine Serienschaltung eines ersten und eines zweiten Halbleiterschaltelementes Q1, Q2 auf. Das erste steuerbare Halbleiterschaltelement Q1 ist beispielsweise für eine erste Stromrichtung leitfähig und das zweite steuerbare Halbleiterschaltelement Q2 für die entgegengesetzte Stromrichtung.

Dem ersten Halbleiterschaltelement Q1 ist eine erste Diode D1, die in der entgegengesetzten Stromrichtung wie das erste Halbleiterschaltelement Q1 leitfähig ist, und dem zweiten Halbleiterschaltelement Q2 ist eine zweite Diode D2, die in der ersten Stromrichtung des ersten Halbleiterschaltelementes Q1 leitfähig ist, parallel geschaltet.

Die Schalteinrichtung SCH ist mit zweipoligen Anschlüssen ausgeführt (für Plus- und Minusleiter), im Beispiel befinden sich die ersten und zweiten Halbleiterschaltelemente Q1, Q2 in einem Leiter, im Beispiel im Plusleiter; der Minusleiter ist durchgeführt und weist keine Halbleiterschaltelemente auf.

Alternativ können die Halbleiterschaltelemente auch im Minusleiter angeordnet sein bzw. beide Leiter können Halbleiterschaltelemente aufweisen.

Der Serienschaltung der beiden Halbleiterschaltelemente Q1, Q2 folgt geräteseitig bzw. gleichspannungsabzweigseitig ein Trennkontakt, wobei für den Plusleiter ein erster Trennkontakt TK1 und den Minusleiter ein zweiter Trennkontakt TK2 vorgesehen sind, allgemein als Trennkontakt bzw. Trennkontakte bezeichnet, zur galvanischen Trennung des Gleichspannungsabzweiges bzw. Gerätes.

Die Schalteinrichtung SCH kann auch andersartig aufgebaut sein, beispielsweise durch die Parallelschaltung zweier Halbleiterschaltelemente Q1, Q2. Wobei jedem der Halbleiterschaltelemente Q1, Q2 eine Diode in Serie geschaltet kann sein und diese Serienschaltung parallel geschaltet wird. Andere Varianten sind ebenso denkbar.

Im Folgenden soll die Erfindung nochmals mit anderen Worten dargestellt werden.

In Gleichspannungsnetzen mit verteilten Kapazitäten in den Lastabgängen und Einspeisepfaden kann künftig der Schutz von Maschinen und Betriebsmitteln durch leistungselektronische Gleichspannungsschalter (Schalter) realisiert werden. Dabei wird Selektivität der Schalter erwartet. Selektivität erfordert nun, dass (dauerhaft) nur der fehlerhafte Abzweig abgeschaltet wird und alle anderen Zweige aktiv bleiben.

Halbleiter-basierte Schaltelemente wie Si-IGBTs oder SiC MOS-FETs erreichen einen Sättigungsstrom, der kleiner ist als die Kurzschlussströme im Fehlerfall. Da diese schaltenden Elemente einen solchen Sättigungsstrom nur für kurze Zeit (im ps-Bereich) tragen können, müssen diese Schalter zum Eigenschutz ausschalten, ohne Berücksichtigung der geforderten Selektivität in einem solchen Gleichspannungssystem.

Erfindungsgemäß werden zwei Möglichkeiten für die Realisierung der Selektivität vorgeschlagen:

A: Auswerten des Kurzschlussstroms und Spannung vor Abschaltung des Schalters,
B: Auswertung der Spannung nach Abschaltung des Schalters und ggf. schnelle Wiederzuschaltung.

In Gleichspannungsnetzen mit verteilten Kapazitäten und treibenden Leitungsinduktivitäten sollen bidirektionale, leistungselektronische Schalter für den Schutz der Abgänge eingesetzt werden. Diese Schalter können für den Eigenschutz über eine Strom- und Spannungsmessung (nicht nur über Emitter-Kollektor, sondern zwischen den Polen) verfügen. Damit können die Größen Strom, Stromanstiegsrate, Spannung und Spannungsänderungsgeschwindigkeit erfasst werden.

Aus der Stromrichtung kann ein Gleichspannungsschalter, wie ein Abgangsschalter S1, ermitteln, ob der Fehler in seinem Gleichspannungsabzweig bzw. Abgang aufgetreten ist und er dauerhaft ausschalten muss, sofern der Fehler als solcher aus Stromanstieg und Spannungseinbruch sicher erkannt wird.

Wenn ein Schalter zum Eigenschutz abschalten muss, können die o.g. Größen erfasst und für eine Auswertung durch einen Mikrocontroller bzw. Controller im Schalter gepuffert werden. Für den Betrieb des Schalters ist dabei vorteilhaft eine weiterhin verfügbare Steuerspannung vorhanden.

Für die zweiten und dritten Gleichspannungsschalter S2, S3 in benachbarten Abzweigen bzw. Abgängen vergleichbarer oder kleinerer Leistung erfolgt der Stromfluss im Fehlerfall in Rückwärtsrichtung, zum Gleichspannungsbus bzw. zur DC-Verteilung hin, und er kann über die Tiefe des Spannungseinbruchs (Entladung der Kapazität im Abgang) und einer wiederkehrenden Spannung durch weiter speisende Pfade und Leitungsinduktivitäten zusätzlich einen Zeitpunkt für die Wiederzuschaltung bestimmen, die im Millisekundenbereich / ms-Bereich liegen wird.

$$U_s(t) = R_L \cdot I_s(t) + L_L(dI_s(t)/dt) - \int I_s(t)/C \, dt + UFehler$$

Falls Schalter zum Eigenschutz abschalten müssen, können S2 und S3 aufgrund der Stromrichtung entscheiden, so schnell wie möglich wieder zu zuschalten. In diesem Fall würde S4 eine Rückkehr der DC-Spannung erkennen und könnte, falls er abgeschaltet hätte, ebenfalls sehr schnell wieder zuschalten. S1 bleibe aufgrund des Kurzschlusses und damit der Spannungslosigkeit am Abgang geöffnet.

Die Erfindung hat den Vorteil, dass gegenüber einem Schutz mit elektromechanischen Leistungsschaltern Selektivität in kapazitätsgepufferten Gleichspannungsnetzen gewährleistet werden kann, wenn leistungselektronische Schalter, nach systemangepassten Kriterien nicht abschalten bzw. wieder zuschalten und die nicht-fehlerhaften Abgänge weiter versorgen können, bevor die Kapazitäten vollständig entladen sind und das System neu gestartet werden muss.

Insbesondere werden für die Kriterien nicht nur der fließende Strom, sondern auch die Spannung und deren jeweilige Änderung berücksichtigt. Dafür ist schnelles Ab- und wieder Zuschalten durch leistungselektronische Schalter entscheidend.

Vorteilhaft ist eine verbesserte Selektivität ohne Überdimensionierung der Halbleiter-Schalter.

**Patentansprüche**

1. Gleichspannungsschalter (Sx) zum Koppeln eines für mindestens ein Gleichspannungsgerät (Gx) vorgesehenen Gleichspannungsabzweiges (DCA, DCA1, DCA2, DCA3) mit einem Plus- und einem Minusleiter an einen Gleichspannungsbus (DCB);

   wobei in einer Vorwärtsrichtung der elektrische Strom vom Plusleiter (DCP) des Gleichspannungsbusses (DCB) über den Gleichspannungsschalter (Sx) zum Plusleiter des Gleichspannungsabzweiges (DCA) und vom Minusleiter des Gleichspannungsabzweiges (DCA) über den Gleichspannungsschalter (Sx) zum Minusleiter (DCN) des Gleichspannungsbusses (DCB) fließt,
   sowie in einer Rückwärtsrichtung der elektrische Strom vom Plusleiter des Gleichspannungsabzweiges (DCA) über den Gleichspannungsschalter (Sx) zum Plusleiter (DCP) des Gleichspannungsbusses (DCB) und vom Minusleiter (DCN) des Gleichspannungsbusses (DCB) über den Gleichspannungsschalter (Sx) zum Minusleiter des Gleichspannungsabzweiges (DCA) fließt;
   der Gleichspannungsschalter (Sx) aufweisend:

      eine halbleiterbasierte, elektronisch steuerbare Schalteinrichtung (SCH),
      einen vor der Schalteinrichtung (SCH) vorgesehenen gleichspannungsbusseitigen Spannungssensor (U1), zur Ermittlung der gleichspannungsbusseitigen (DCB) Spannungshöhe,
      einen nach der Schalteinrichtung (SCH) vorgesehenen gleichspannungsabzweigseitigen Spannungssensor (U2), zur Ermittlung der gleichspannungsabzweigseitigen (DCA) Spannungshöhe,
      einen Stromsensor (I) zur Ermittlung der Stromhöhe und der Stromrichtung,
      **gekennzeichnet durch**,
      eine Steuereinrichtung (SE), die mit der Schalteinrichtung (SCH), den Spannungssensoren (U1, U2) und dem Stromsensor (I) verbunden ist, wobei die Steuereinrichtung (SE) derart ausgestaltet ist, dass

         - die Richtung des Stromes und die Stromhöhe ermittelt wird,
         - bei Überschreitung eines ersten Schwellwertes der Stromhöhe eine Unterbrechung des Stromflusses **durch** die Schalteinrichtung (SCH) erfolgt,
         - falls bei Überschreitung des ersten Schwellwertes der Stromhöhe die ermittelte Richtung des Stroms die Rückwärtsrichtung ist:
- nach Unterbrechung des Stromflusses die gleichspannungsbusseitige (DCB) mit der gleichspannungsabzweigseitigen (DCA) Spannungshöhe verglichen wird und bei einem Spannungsunterschied, der kleiner als ein Spannungsdifferenzwert ist, die Schalteinrichtung (SCH) leitfähig geschaltet wird.

2. Gleichspannungsschalter (Sx) nach Patentanspruch 1,
**dadurch gekennzeichnet,**
**dass** die Schalteinrichtung (SCH) mindestens ein, insbesondere zwei, den plus- oder minusleiterseitigen Stromfluss führendes Halbleierschaltelement (Q1, Q2) aufweist.

3. Gleichspannungsschalter (Sx) nach Patentanspruch 2, **dadurch gekennzeichnet,**
**dass** das Halbleiterschaltelement (Q1, Q2) ein Bipolartransistor mit isolierter Gate-Elektrode, ein Metall-Oxid-Halbleiter-Feldeffekttransistor oder ein Galliumnitrid-Transistor ist.

4. Gleichspannungsschalter (Sx) nach Patentanspruch 2 oder 3, **dadurch gekennzeichnet,**
**dass** dem Halbleiterschaltelement (Q1, Q2) eine Diode (D1, D2) parallel geschaltet ist, insbesondere mit ihrer Durchlassrichtung entgegen der Durchlassrichtung des Halbleiterschaltelementes (Q1, Q2).

5. Gleichspannungsschalter (Sx) nach Patentanspruch 4, **dadurch gekennzeichnet,**
**dass** die Diode (D1, D2) eine niedrige Durchlassspannung aufweist, insbesondere eine Netzdiode oder Schottkydiode ist.

6. Gleichspannungsschalter (Sx) nach einem der vorhergehenden Patentansprüche,
**dadurch gekennzeichnet,**
**dass** der Gleichspannungsschalter (Sx) in einem Gehäuse (GEH) angeordnet sind.

7. Gleichspannungsschalter (Sx) nach Patentanspruch 6, **dadurch gekennzeichnet,**

**dass** das Gehäuse (GEH) einen Plusleitereingangsanschluss (PE), einen Minusleitereingangsanschluss (ME), einen Plusleiterausgangsanschluss (PA) und einen Minusleiterausgangsanschluss (MA) aufweist;
**dass** die Eingangsanschlüsse (PE, ME) mit dem Gleichspannungsbus (DCB) verbindbar sind;
**dass** die Ausgangsanschlüsse (PA, MA) mit dem Gleichspannungsabzweig (DCA) verbindbar sind;
**dass** entweder die Schalteinrichtung (SCH) zwischen Plusleitereingangsanschluss (PE) und Plusleiterausgangsanschluss (PA) vorgesehen ist oder/und
die Schalteinrichtung (SCH) zwischen Minusleitereingangsanschluss (ME) und Minusleiterausgangsanschluss (MA) vorgesehen ist.

8. Gleichspannungsschalter (Sx) nach Patentanspruch 7, **dadurch gekennzeichnet,**
**dass** die nicht die Schalteinrichtung (SCH) aufweisenden Anschlüsse durch eine elektrische Leitung miteinander verbunden sind.

9. Gleichspannungsschalter (Sx) nach einem der vorhergehenden Patentansprüche,
**dadurch gekennzeichnet,**
**dass** der Spannungsdifferenzwert 10 Volt beträgt.

10. Gleichspannungsschalter (Sx) nach einem der vorhergehenden Patentansprüche,
**dadurch gekennzeichnet,**
**dass** der Gleichspannungsschalter (Sx) ein Abgangsschalter ist oder in einem Abgangsschalter eingesetzt ist.

11. Gleichspannungsschalter (Sx) nach einem der vorhergehenden Patentansprüche,
**dadurch gekennzeichnet,**
**dass** der Stromsensor (I) ein Sensor auf Basis der Hall-Effekts ist.

12. Gleichspannungsschalter (Sx) nach einem der vorhergehenden Patentansprüche,
**dadurch gekennzeichnet,**
**dass** die Steuereinrichtung (SE) ferner derart ausgestaltet ist, dass bei einem Anstieg des Stromes, der einen Stromanstiegsschwellwert überschreitet, eine Unterbrechung des Stromflusses durch die Schalteinrichtung erfolgt.

**13.** Gleichspannungsschalter (Sx) nach einem der vorhergehenden Patentansprüche,
**dadurch gekennzeichnet,**
**dass** ein Netzteil, Energiespeicher oder ein Anschluss für eine externe Energieversorgung zur Energieversorgung der Steuereinrichtung (SE) vorgesehen ist.

**14.** Gleichspannungsschalter (Sx) nach einem der vorhergehenden Patentansprüche,
**dadurch gekennzeichnet,**
**dass** die Steuereinrichtung (SE) einen Mikroprozessor aufweist.

**15.** Gleichspannungsabzweig (DCA), der einen Gleichspannungsschalter (Sx) nach einem der Patentansprüche 1 bis 14 aufweist, wobei der Gleichspannungsschalter (Sx) einerseits mit einem Gleichspannungsbus (DCB) und andererseits mit Geräten (Gx), insbesondere Verbrauchern, verbunden ist.

**16.** Verfahren zum Koppeln eines für mindestens ein Gleichspannungsgerät (Gx) vorgesehenen Gleichspannungsabzweig (DCA, DCA1, DCA2, DCA3) mit einem Plus- und einem Minusleiter an einen Gleichspannungsbus (DCB);

wobei in einer Vorwärtsrichtung der elektrische Strom vom Plusleiter (DCP) des Gleichspannungsbusses (DCB) über einen Gleichspannungsschalter (Sx), mit einer Schalteinrichtung (SCH), zum Plusleiter des Gleichspannungsabzweiges (DCA) und vom Minusleiter des Gleichspannungsabzweiges (DCA) über den Gleichspannungsschalter (Sx) zum Minusleiter (DCN) des Gleichspannungsbusses (DCB) fließt,
sowie in einer Rückwärtsrichtung der elektrische Strom vom Plusleiter des Gleichspannungsabzweiges (DCA) über den Gleichspannungsschalter (Sx) zum Plusleiter (DCP) des Gleichspannungsbusses (DCB) und vom Minusleiter (DCN) des Gleichspannungsbusses (DCB) über den Gleichspannungsschalter (Sx) zum Minusleiter des Gleichspannungsabzweiges (DCA) fließt; dass die gleichspannungsbusseitige (DCB) Spannungshöhe ermittelt wird,
dass die gleichspannungsabzweigseitige (DCA) Spannungshöhe ermittelt wird,
**dadurch gekennzeichnet, dass**
die Stromhöhe und die Stromrichtung ermittelt wird,
bei Überschreitung eines ersten Schwellwertes der Stromhöhe eine Unterbrechung des Stromflusses durch die Schalteinrichtung erfolgt,
falls bei Überschreitung des ersten Schwellwertes der Stromhöhe die ermittelte Richtung des Stroms die Rückwärtsrichtung ist:
nach Unterbrechung des Stromflusses die gleichspannungsbusseitige (DCB) mit der gleichspannungsabzweigseitigen (DCA) Spannungshöhe verglichen wird und bei einem Spannungsunterschied, der kleiner als ein Spannungsdifferenzwert ist, die Schalteinrichtung (SCH) leitfähig geschaltet wird.

**Claims**

**1.** DC voltage switch (Sx) for coupling a DC voltage branch (DCA, DCA1, DCA2, DCA3) to a DC voltage bus (DCB), said DC voltage branch being provided for at least one DC voltage device (Gx) and having a positive conductor and a negative conductor;

wherein in a forward direction the electric current flows from the positive conductor (DCP) of the DC voltage bus (DCB) via the DC voltage switch (Sx) to the positive conductor of the DC voltage branch (DCA) and from the negative conductor of the DC voltage branch (DCA) via the DC voltage switch (Sx) to the negative conductor (DCN) of the DC voltage bus (DCB),
and in a reverse direction the electric current flows from the positive conductor of the DC voltage branch (DCA) via the DC voltage switch (Sx) to the positive conductor (DCP) of the DC voltage bus (DCB) and from the negative conductor (DCN) of the DC voltage bus (DCB) via the DC voltage switch (Sx) to the negative conductor of the DC voltage branch (DCA);
the DC voltage switch (Sx) comprising:

a semiconductor-based, electronically controllable switching device (SCH),
a DC voltage bus-side voltage sensor (U1) provided upstream of the switching device (SCH), for determining the DC voltage bus-side (DCB) voltage level,
a DC voltage branch-side voltage sensor (U2) provided downstream of the switching device (SCH), for determining the DC voltage branch-side (DCA) voltage level,

a current sensor (I) for determining the current level and the current direction,
**characterized by**
a control device (SE) connected to the switching device (SCH), the voltage sensors (U1, U2) and the current sensor (I), wherein the control device (SE) is configured in such a way that

- the direction of the current and the current level are determined,
- in the event of a first threshold value of the current level being exceeded, the current flow through the switching device (SCH) is interrupted,
- if, in the event of the first threshold value of the current level being exceeded, the determined direction of the current is the reverse direction:
- after interruption of the current flow, the DC voltage bus-side (DCB) voltage level is compared with the DC voltage branch-side (DCA) voltage level and the switching device (SCH) is switched into the on state in the event of a voltage difference that is less than a voltage difference value.

2. DC voltage switch (Sx) according to Patent Claim 1, **characterized in that** the switching device (SCH) comprises at least one, in particular two, semiconductor switching element(s) (Q1, Q2) carrying the positive or negative conductor-side current flow.

3. DC voltage switch (Sx) according to Patent Claim 2, **characterized in that** the semiconductor switching element (Q1, Q2) is an insulated gate bipolar transistor, a metal oxide semiconductor field effect transistor or a gallium nitride transistor.

4. DC voltage switch (Sx) according to Patent Claim 2 or 3, **characterized in that** a diode (D1, D2) is connected in parallel with the semiconductor switching element (Q1, Q2), in particular with the forward direction of said diode counter to the forward direction of the semiconductor switching element (Q1, Q2).

5. DC voltage switch (Sx) according to Patent Claim 4, **characterized in that** the diode (D1, D2) has a low forward voltage, and in particular is a network diode or a Schottky diode.

6. DC voltage switch (Sx) according to any of the preceding patent claims, **characterized in that** the DC voltage switch (Sx) is arranged in a housing (GEH) .

7. DC voltage switch (Sx) according to Patent Claim 6, **characterized**

**in that** the housing (GEH) comprises a positive conductor input connection (PE), a negative conductor input connection (ME), a positive conductor output connection (PA) and a negative conductor output connection (MA);
**in that** the input connections (PE, ME) are connectable to the DC voltage bus (DCB);
**in that** the output connections (PA, MA) are connectable to the DC voltage branch (DCA);
**in that** either the switching device (SCH) is provided between positive conductor input connection (PE) and positive conductor output connection (PA) or/and
the switching device (SCH) is provided between negative conductor input connection (ME) and negative conductor output connection (MA).

8. DC voltage switch (Sx) according to Patent Claim 7, **characterized in that** the connections not comprising the switching device (SCH) are connected to one another by an electrical line.

9. DC voltage switch (Sx) according to any of the preceding patent claims, **characterized in that** the voltage difference value is 10 volts.

10. DC voltage switch (Sx) according to any of the preceding patent claims, **characterized in that** the DC voltage switch (Sx) is an outgoer switch or is used in an outgoer switch.

11. DC voltage switch (Sx) according to any of the preceding patent claims, **characterized in that** the current sensor (I) is a Hall effect-based sensor.

12. DC voltage switch (Sx) according to any of the preceding patent claims,
**characterized**
**in that** the control device (SE) is furthermore configured in such a way that in the event of a rise in the current that exceeds a current rise threshold value, the current flow through the switching device is interrupted.

13. DC voltage switch (Sx) according to any of the preceding patent claims,
**characterized**
**in that** a power supply unit, an energy store or a connection for an external energy supply is provided for supplying energy to the control device (SE).

14. DC voltage switch (Sx) according to any of the preceding patent claims,
**characterized**
**in that** the control device (SE) comprises a microprocessor.

15. DC voltage branch (DCA) comprising a DC voltage switch (Sx) according to any of Patent Claims 1 to 14, wherein the DC voltage switch (Sx) is connected to a DC voltage bus (DCB) at one end and to devices (Gx), in particular loads, at the other end.

16. Method for coupling a DC voltage branch (DCA, DCA1, DCA2, DCA3) to a DC voltage bus (DCB), said DC voltage branch being provided for at least one DC voltage device (Gx) and having a positive conductor and a negative conductor;

wherein in a forward direction the electric current flows from the positive conductor (DCP) of the DC voltage bus (DCB) via a DC voltage switch (Sx), with a switching device (SCH), to the positive conductor of the DC voltage branch (DCA) and from the negative conductor of the DC voltage branch (DCA) via the DC voltage switch (Sx) to the negative conductor (DCN) of the DC voltage bus (DCB),
and in a reverse direction the electric current flows from the positive conductor of the DC voltage branch (DCA) via the DC voltage switch (Sx) to the positive conductor (DCP) of the DC voltage bus (DCB) and from the negative conductor (DCN) of the DC voltage bus (DCB) via the DC voltage switch (Sx) to the negative conductor of the DC voltage branch (DCA);
wherein the DC voltage bus-side (DCB) voltage level is determined,
wherein the DC voltage branch-side (DCA) voltage level is determined,
**characterized in that**
the current level and the current direction are determined,
in the event of a first threshold value of the current level being exceeded, the current flow through the switching device is interrupted,
if, in the event of the first threshold value of the current level being exceeded, the determined direction of the current is the reverse direction:
after interruption of the current flow, the DC voltage bus-side (DCB) voltage level is compared with the DC voltage branch-side (DCA) voltage level and the switching device (SCH) is switched into the on state in the event of a voltage difference that is less than a voltage difference value.

**Revendications**

1. Commutateur de tension continue (Sx) destiné au couplage d'une dérivation de tension continue (DCA, DCA1, DCA2, DCA3) prévue pour au moins un appareil à tension continue (Gx) avec un conducteur positif et un conducteur négatif au niveau d'un bus de tension continue (DCB) ;

dans lequel dans une direction avant le courant électrique circule du conducteur positif (DCP) du bus de tension continue (DCB) au conducteur positif de la dérivation de tension continue (DCA) en passant par le commutateur de tension continue (Sx) et du conducteur négatif de la dérivation de tension continue (DCA) au conducteur négatif (DCN) du bus de tension continue (DCB) en passant par le commutateur de tension continue (Sx),
ainsi que dans une direction arrière le courant électrique circule du conducteur positif de la dérivation de tension continue (DCA) au conducteur positif (DCP) du bus de tension continue (DCB) en passant par le commutateur de tension continue (Sx) et du conducteur négatif (DCN) du bus de tension continue (DCB) au conducteur négatif de la dérivation de tension continue (DCA) en passant par le commutateur de tension continue (Sx) ; le commutateur de tension continue (Sx) présentant :

un dispositif de commutation à base de semi-conducteurs pouvant être commandé électroniquement (SCH),
un capteur de tension (U1) côté bus de tension continue prévu en amont du dispositif de commutation (SCH), destiné à la détermination du niveau de tension côté bus de tension continue (DCB),
un capteur de tension (U2) côté dérivation de tension continue prévu en aval du dispositif de commutation (SCH), destiné à la détermination du niveau de tension côté dérivation de tension continue (DCA), un capteur de courant (I) destiné à la détermination du niveau de courant et à la direction de courant, **caractérisé par** un dispositif de commande (SE) qui est relié au dispositif de commutation (SCH), aux capteurs de tension (U1, U2) et au capteur de courant (I), dans lequel le dispositif de commande (SE) est conçu de telle sorte que

- la direction du courant et le niveau de courant sont déterminés,
- lors d'un dépassement d'une première valeur de seuil du niveau de courant une interruption de la circulation de courant se produit par le biais du dispositif de commutation (SCH),
- lors d'un dépassement de la première valeur de seuil du niveau de courant la direction déterminée du courant est la direction arrière :
- après l'interruption de la circulation de courant le niveau de tension côté bus de tension continue (DCB) est comparé au niveau de tension côté dérivation de tension continue (DCA) et lors d'une différence de tension qui est plus petite qu'une valeur de différence de tension, le dispositif de commutation (SCH) est commuté pour être conducteur.

2. Commutateur de tension continue (Sx) selon la revendication 1,
**caractérisé en ce que**
le dispositif de commutation (SCH) présente au moins un, en particulier deux, élément(s) de commutation à semi-conducteurs (Q1, Q2) conducteur(s) de circulation de courant côté conducteur positif ou négatif.

3. Commutateur de tension continue (Sx) selon la revendication 2,
**caractérisé en ce que**
l'élément de commutation à semi-conducteurs (Q1, Q2) est un transistor bipolaire avec une électrode grille isolée, un transistor à effet de champ à semi-conducteurs à oxyde métallique ou un transistor au nitrure de gallium.

4. Commutateur de tension continue (Sx) selon la revendication 2 ou 3,
**caractérisé en ce que**
une diode (D1, D2) est commutée parallèlement à l'élément de commutation à semi-conducteurs (Q1, Q2), en particulier avec sa direction de traversée dans le sens inverse de la direction de traversée de l'élément de commutation à semi-conducteurs (Q1, Q2) .

5. Commutateur de tension continue (Sx) selon la revendication 4,
**caractérisé en ce que**
la diode (D1, D2) présente une tension de traversée basse, et est en particulier une diode d'alimentation ou une diode Schottky.

6. Commutateur de tension continue (Sx) selon l'une quelconque des revendications précédentes,
**caractérisé en ce que**
le commutateur de tension continue (Sx) est agencé dans un boîtier (GEH).

7. Commutateur de tension continue (Sx) selon la revendication 6,
**caractérisé en ce que**

le boîtier (GEH) présente une borne d'entrée de conducteur positif (PE), une borne d'entrée de conducteur négatif (ME), une borne de sortie de conducteur positif (PA) et une borne de sortie de conducteur négatif (MA) ;
les bornes d'entrée (PE, ME) peuvent être reliées au bus de tension continue (DCB) ;
les bornes de sortie (PA, MA) peuvent être reliées à la dérivation de tension continue (DCA) ;
soit le dispositif de commutation (SCH) est prévu entre la borne d'entrée de conducteur positif (PE) et la borne de sortie de conducteur positif (PA) soit/et
le dispositif de commutation (SCH) est prévu entre la borne d'entrée de conducteur négatif (ME) et la borne de sortie de conducteur négatif (MA).

8. Commutateur de tension continue (Sx) selon la revendication 7,
**caractérisé en ce que**

les bornes qui ne présentent pas le dispositif de commutation (SCH) sont reliées entre elles par le biais d'une ligne électrique.

9. Commutateur de tension continue (Sx) selon l'une quelconque des revendications précédentes,
   **caractérisé en ce que**
   la valeur de différence de tension est de 10 volts.

10. Commutateur de tension continue (Sx) selon l'une quelconque des revendications précédentes,
    **caractérisé en ce que**
    le commutateur de tension continue (Sx) est un commutateur de départ ou est employé dans un commutateur de départ.

11. Commutateur de tension continue (Sx) selon l'une quelconque des revendications précédentes,
    **caractérisé en ce que**
    le capteur de courant (I) est un capteur basé sur l'effet de Hall.

12. Commutateur de tension continue (Sx) selon l'une quelconque des revendications précédentes,
    **caractérisé en ce que**
    le dispositif de commande (SE) est en outre conçu de telle sorte que lors d'une augmentation du courant qui dépasse une valeur de seuil d'augmentation de courant, une interruption de la circulation de courant se produit par le biais du dispositif de commutation.

13. Commutateur de tension continue (Sx) selon l'une quelconque des revendications précédentes,
    **caractérisé en ce que**
    une alimentation secteur, un réservoir d'énergie ou une borne pour une alimentation en énergie externe destinée à l'alimentation en énergie du dispositif de commande (SE) est prévue.

14. Commutateur de tension continue (Sx) selon l'une quelconque des revendications précédentes,
    **caractérisé en ce que**
    le dispositif de commande (SE) présente un microprocesseur.

15. Dérivation de tension continue (DCA) qui présente un commutateur de tension continue (Sx) selon l'une quelconque des revendications 1 à 14, dans laquelle le commutateur de tension continue (Sx) est relié d'une part à un bus de tension continue (DCB) et d'autre part à des appareils (Gx), en particulier des consommateurs.

16. Procédé destiné au couplage d'une dérivation de tension continue (DCA, DCA1, DCA2, DCA3) prévue pour au moins un appareil à tension continue (Gx) avec un conducteur positif et un conducteur négatif au niveau d'un bus de tension continue (DCB) ; dans lequel dans une direction avant le courant électrique circule du conducteur positif (DCP) du bus de tension continue (DCB) au conducteur positif de la dérivation de tension continue (DCA) en passant par un commutateur de tension continue (Sx) avec un dispositif de commutation (SCH) et du conducteur négatif de la dérivation de tension continue (DCA) au conducteur négatif (DCN) du bus de tension continue (DCB) en passant par le commutateur de tension continue (Sx),

    ainsi que dans une direction arrière le courant électrique circule du conducteur positif de la dérivation de tension continue (DCA) au conducteur positif (DCP) du bus de tension continue (DCB) en passant par le commutateur de tension continue (Sx) et du conducteur négatif (DCN) du bus de tension continue (DCB) au conducteur négatif de la dérivation de tension continue (DCA) en passant par le commutateur de tension continue (Sx) ; le niveau de tension côté bus de tension continue (DCB) est déterminé,
    le niveau de tension côté dérivation de tension continue (DCA) est déterminé,
    **caractérisé en ce que**
    le niveau de courant et la direction de courant sont déterminés, lors d'un dépassement d'une première valeur de seuil du niveau de courant une interruption de la circulation de courant se produit par le biais du dispositif de commutation,
    dans le cas où lors d'un dépassement de la première valeur de seuil du niveau de courant la direction déterminée du courant est la direction arrière :
    après l'interruption de la circulation de courant le niveau de tension côté bus de tension continue (DCB) est comparé au niveau de tension côté dérivation de tension continue (DCA) et lors d'une différence de tension qui est inférieure à une valeur de différence de tension, le dispositif de commutation (SCH) est commuté pour être

conducteur.

FIG 1

FIG 2

FIG 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2014139559 A1